# EUROPÄISCHE PATENTSCHRIFT

(11) **EP 3 987 300 B1**
(45) Veröffentlichungstag und Bekanntmachung des Hinweises auf die Patenterteilung: **16.07.2025**
(21) Anmeldenummer: 20742157.9
(22) Anmeldetag: 09.06.2020
(51) Int. Cl.: G01R 33/028, H10N 35/00, G01R 33/18

(54) **MESSVORRICHTUNG FÜR SCHWACHE, LANGSAM VERÄNDERLICHE MAGNETFELDER, INSBESONDERE FÜR BIOMAGNETISCHE FELDER**
MEASURING DEVICE FOR WEAK AND SLOWLY CHANGING MAGNETIC FIELDS, IN PARTICULAR FOR BIOMAGNETIC FIELDS
DISPOSITIF DE MESURE POUR DES CHAMPS MAGNÉTIQUES FAIBLES, LENTEMENT VARIABLES, EN PARTICULIER POUR DES CHAMPS BIOMAGNÉTIQUES

(30) Priorität: 21.06.2019 DE 102019116779
(43) Veröffentlichungstag der Anmeldung: 27.04.2022
(73) Patentinhaber: Christian-Albrechts-Universität zu Kiel, 24118 Kiel (DE)
(72) Erfinder: QUANDT, Eckhardt, 24226 Heikendorf (DE); KNÖCHEL, Reinhard, 25336 Elmshorn (DE); HAYES, Patrick, 24232 Schönkirchen (DE); TOXVAERD, Sebastian, 6000 Kolding (DK)
(86) Internationale Anmeldenummer: PCT/DE2020/100483
(87) Internationale Veröffentlichungsnummer: WO 2020/253908

(56) Entgegenhaltungen:
- US-A1- 2015 247 904
- US-A1- 2018 299 514
- HAYES P ET AL: "Electrically modulated magnetoelectric AlN/FeCoSiB film composites for DC magnetic field sensing", JOURNAL OF PHYSICS D: APPLIED PHYSICS, INSTITUTE OF PHYSICS PUBLISHING LTD, GB, vol. 51, no. 35, 1 August 2018 (2018-08-01), pages 354002, XP020330294, ISSN: 0022-3727, [retrieved on 20180801], DOI: 10.1088/1361-6463/AAD456

## Beschreibung

Die Erfindung betrifft eine Vorrichtung zur Messung eines Magnetfeldes aufweisend einen einseitig eingespannten, mechanisch schwingungsfähigen, magnetischen oder magnetisch beschichteten Ausleger, weiterhin aufweisend Antriebsmittel ausgebildet zur zeitlich periodischen Anregung einer Schwingung des Auslegers mit einer vorbestimmten Anregungsfrequenz und aufweisend eine Detektionseinrichtung zur Erfassung eines durch die Schwingung des Auslegers erzeugten elektrischen Signals.

Gattungsgemäße Vorrichtungen zur Magnetfeldmessung sind beispielsweise aus den Druckschriften GB 2319621 A, US 2009/015250 A1, US 2018/299514 A1 bekannt. Der Grundgedanke ist in allen Fällen, die Einwirkung eines zu messenden externen Magnetfeldes - i. F. Messmagnetfeld genannt - auf die mechanischen Eigenschaften des magnetischen oder magnetisch beschichteten Auslegers in eine elektrische Größe umzuwandeln und als solche zu erfassen. Für die Detektion sehr schwacher Magnetfelder ist es dabei üblich, den Ausleger in einer mechanischen Resonanzmode anzuregen, so dass es zu einer physikalischen Verstärkung der Messgröße bereits bei ihrer Erzeugung - also noch vor der technischen Realisierung der Messwerterfassung - kommt. In den genannten Druckschriften werden etwa die zeitliche Änderung des magnetischen Flusses in einer Spule, die Ablenkung eines am freien Ende des schwingenden Auslegers reflektierten Lichtstrahls oder die in einer piezoelektrischen Schicht auf dem verformten Ausleger generierte Piezospannung als resonanzüberhöhte Messgrößen detektiert und ggf. noch in elektrische Signale umgewandelt und - i.d.R. digitalisiert - kontinuierlich erfasst.

Die Auswertung der gemessenen Signale erlaubt das Rückschließen auf den Resonanzzustand des schwingenden Auslegers zu beliebigen Zeitpunkten und gestattet dadurch das Auffinden von Änderungen der mechanischen Eigenschaften des Auslegers. Diese werden wiederum auf die Anwesenheit einer räumlichen Messmagnetfeldkomponente zurückgeführt. Die Präsenz eines Messmagnetfeldes moduliert das elektrische Signal des Auslegers in Amplitude und/oder Frequenz, und die Modulation kann mit bekannten Verfahren der Signalverarbeitung separiert werden. Mittels geeigneter Kalibrierung lassen sich daraus Amplitude und Frequenz des Messmagnetfeldes mit hoher Sensitivität quantitativ bestimmen.

Es ist grundsätzlich bemerkenswert, dass sich kleine, kompakte Messvorrichtungen mit mechanisch oszillierenden Auslegern in MEMS-Bauweise mit mechanischen Resonanzfrequenzen im hohen Kilohertz-Bereich herstellen lassen, die auch geeignet sind, langsam veränderliche Messmagnetfelder mit Frequenzen der Größenordnung 100 Millihertz zuverlässig zu detektieren. Dies eröffnet die Möglichkeit der Massenfertigung preiswerter, miniaturisierter Magnetfeldsensoren, die in der Lage sind, sehr schwache niederfrequente Magnetfelder zu detektieren, wie sie etwa in lebenden Organismen erzeugt werden.

Biomagnetische Sensor-Arrays sind ein Fernziel gegenwärtiger Forschung und Entwicklung. Neben der absehbaren Erweiterung der medizinischen Diagnostik durch die auf Magnetfeldmessung basierende präzise Modellierung von bioelektrischen Strömen in Herz- oder Nervenzellen eröffnet sich auch ein weites Feld für innovative Mensch-Maschine-Interaktionen, die letzten Endes z.B. auf die "Gedankensteuerung" von Werkzeugen aller Art abzielen können.

Gegenwärtig werden verschiedene Sensorkonzeptionen untersucht und erprobt. Zu den vielversprechenden Kandidaten zählt dabei der magnetoelektrische Bimorph, der als einseitig oder beidseitig eingespannter Biegebalken aus einem magnetoelektrischen (ME) Komposit gebildet werden kann. Das ME-Komposit setzt sich dabei aus einer piezoelektrischen und einer magnetostriktiven Materialphase zusammen, die miteinander stoffschlüssig verbunden sind. Unter der Voraussetzung geeigneter Polung bzw. Magnetisierung der Materialphasen ruft ein Messmagnetfeld eine Längenänderung in der magnetostriktiven Phase hervor, die sich auf die piezoelektrische Phase überträgt und dort eine Piezospannung erzeugt. Der Bimorph verbiegt sich dabei, und die Piezospannung liefert ein direktes Maß für die Auslenkung.

Das Komposit kann freitragend ausgestaltet sein, etwa indem die magnetostriktive Materialphase als Dickschicht auf der - zuvor gepolten - piezoelektrischen Materialphase als Substrat abgeschieden wird.

Beispielsweise lassen sich durch Abscheidung komplexe und vorteilhafte magnetostriktive Schichtsysteme unter Einprägung eines Exchange Bias (EB) Feldes erzeugen, wie sie in der Druckschrift US 2014/125332 A1 beschrieben sind. Die freitragenden ME-Biegebalken entstehen dort durch Vereinzelung eines beschichteten Wafers in Streifen, wobei die Kenntnis der Richtung des EB-Feldes es erlaubt, die Ausrichtung der langen Streifenachse so zu wählen, dass die Streifen den maximalen piezomagnetischen Koeffizienten besitzen.

Überhaupt sind die ME-Biegebalken üblich als Streifen ausgebildet, d.h. es handelt sich um Quader aufweisend eine Dicke T ("thickness"), eine Breite W ("width" = Streifenbreite, auch oft als "Länge der kurzen Achse" bezeichnet) und eine Länge L (der langen Achse), die ungefähr das Verhältnis T : W : L = 1 : 10 : 100 besitzen. Die Länge L beträgt typisch mehrere Millimeter, manchmal einige Zentimeter. Der Begriff Streifen wird in dieser Beschreibung für einen Quader verwendet, dessen Seitenlängen sich jeweils um etwa eine oder zwei Größenordnungen voneinander unterscheiden. Vor diesem Hintergrund ist der Streifen ein flaches, rechteckiges Objekt, das zwei Flachseiten aufweist, die beide von der kurzen und der langen Achse des Streifens aufgespannt werden.

Der ME-Biegebalkensensor kann ebenfalls aus einem Substratstreifen aus einem dielektrischen Material gebildet sein, auf dem die piezoelektrische und die magnetostriktive Materialphase als dünne Funktionsschichten abgeschieden werden. In der Druckschrift US 2015/247904 A1 ist beschrieben, dass die Funktionsschichten auf beiden Seiten des Substratstreifens aufgebracht sind, d.h. das Substratmaterial, z.B. mehrere 100 Mikrometer dickes Silizium, ist zwischen einer piezoelektrischen Schicht aus Bleizirkonattitanat (PZT) oder Aluminiumnitrid (AIN) und einer magnetostriktiven Schicht aus einem magnetostriktiven Metglas oder aus dem oben genannten magnetostriktiven Schichtsystem angeordnet. Die Funktionsschichten sind dabei nur wenige Mikrometer dick, und ihre mechanische Kopplung ist durch das dicke Substrat hindurch gewährleistet.

Ein ME-Biegebalken-Sensor in Streifenform wird zur empfindlichen Messung schwacher Magnetfelder zur Schwingung in Resonanzmoden angeregt, die sich numerisch mit Finite-Elemente-Methoden (FEM) berechnen und veranschaulichen lassen. Für einseitig eingespannte Streifen, die entlang ihrer Dickenachse, also hier senkrecht zu den besagten Funktionsschichten auf einem Substratstreifen, durch mechanische Krafteinwirkung angeregt werden, sind die Biegemoden und die Torsionsmoden die häufigsten und wahrscheinlichsten.

Die Massenelemente der Streifen bewegen sich in der resonanten Schwingung vorwiegend entlang der Richtung der anregenden Kraft, wobei Biegemoden dadurch charakterisiert sind, dass die Massenelemente an jedem Punkt der langen Achse des Streifens entlang der kurzen Achse in Phase schwingen. Höhere Biegemoden weisen Knotenlinien entlang der kurzen Achse des Streifens auf, in denen die Massenelemente nicht ausgelenkt werden.

Torsionsmoden zeigen demgegenüber eine Knotenlinie in der Mitte des Streifens entlang der langen Achse, und die Massenelement des Streifens bewegen sich entlang der kurzen Achse zu beiden Seiten dieser Knotenlinie gegenphasig. Der eingespannte Streifen vollführt also eine Art "Schüttelbewegung".

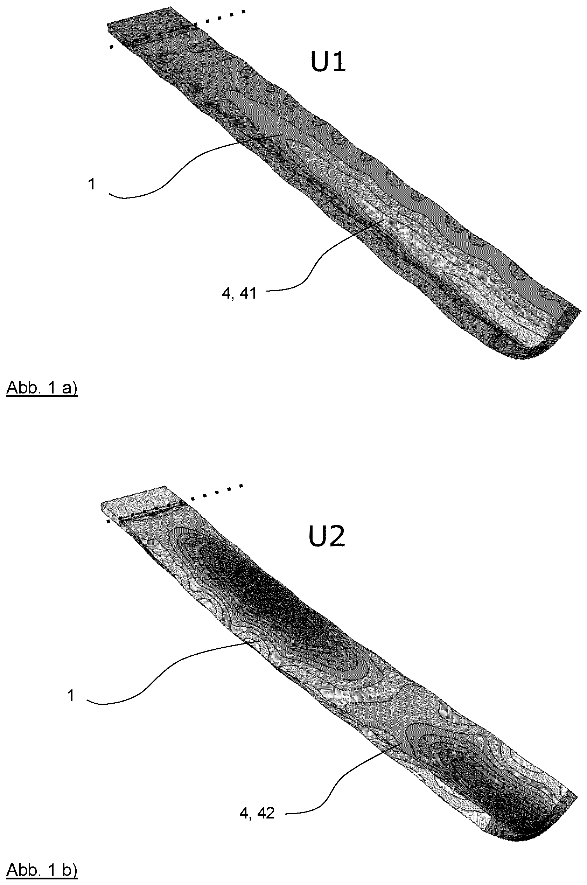

Es existiert in der numerischen Simulation auch noch eine sehr ungewöhnliche Resonanzmodenart, die die Erfinder hier mit dem Namen U-Moden belegen. Sie sind in den Abbildungen 1 a) und 1 b) graphisch dargestellt, und zwar als Mode U1 ohne Knotenlinie und als Mode U2 mit einer Knotenlinie entlang der kurzen Achse des Streifens, der in den Abbildungen am Ende mit dem schwarzen Balken als fixiert modelliert ist. Die U-Moden zeigen Verbiegungen des Streifens vorrangig entlang der kurzen Achse, d.h. jeder Schnitt durch den Streifen senkrecht zur langen Achse weist die mehr oder weniger ausgeprägte Form eines symmetrischen Bogens geöffnet nach oben oder unten auf, also eine U-Form.

Nach Kenntnis der Erfinder wurden die U-Moden bislang nicht mit der Messung von Magnetfeldern durch Sensoren mit Resonanzschwingern in Verbindung gebracht.

Auf die Erfinder geht die Druckschrift von Hayes et al., "Electrically modulated magnetoelectric AlN/FeCoSiB film composites for DC magnetic field sensing", 2018 J. Phys. D: Appl. Phys.51 354002, zurück, in der ein Substratstreifen aus Silizium mit der Dicke 350 Mikrometer auf je einer Seite mit je 2 Mikrometer dicken Funktionsschichten aus (Fe₉₀Co₁₀)₇₈Si₁₂B₁₀ als Vertreter der magnetostriktiven FeCoSiB-Metgläser und gesputtertem Aluminiumnitrid (AIN) zwischen zwei metallischen Elektrodenschichten als piezoelektrischer Materialphase, respektive, beschrieben und untersucht wird. Die Länge des Streifens beträgt 25 Millimeter, seine Breite beträgt 2,45 Millimeter, und die Dicke beträgt ca. 0,354 Millimeter. Der Streifen wird an einem seiner Enden auf einen Haltekörper geklebt, so dass eine Länge von 23 Millimeter übersteht und frei schwingen kann. Die Anregung erfolgt durch einen Frequenzgenerator über eine elektrische Spannung, die an die Piezoschicht angelegt wird, die sich über die ganze Streifenlänge erstreckt.

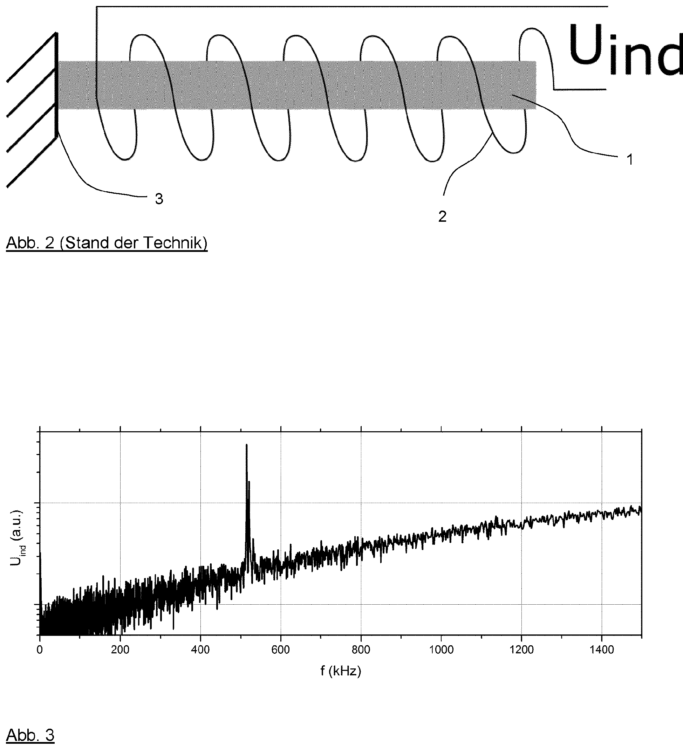

Der schwingende Streifen ist von einer Induktionspule kontaktlos umgeben, deren Spulenachse entlang des Substratstreifens, d.h. entlang seiner langen Achse, ausgerichtet ist, wie schematisch skizziert in Abb. 2. Die Bewegung des Schwingers geht mit der fortlaufenden Verformung der FeCoSiB-Schicht einher und erzeugt so eine zeitliche Änderung des magnetischen Flusses im Innern der Induktionsspule. Die hierdurch induzierte Spannung wird als Ausgangsignal U_{ind} der Spule erfasst.

In Abb. 3 ist in einer neuen Abbildung die Stärke des Ausgangssignals als Funktion der Anregungsfrequenz über das Frequenzband 0 - 1,5 MHz dargestellt. Es zeigen sich zwei deutlich hervortretende Peaks bei 515,7 kHz und 520,7 kHz, wie bereits in der Arbeit von Hayes et al. berichtet wurde. Man beachte die logarithmische Skala für U_{ind}.

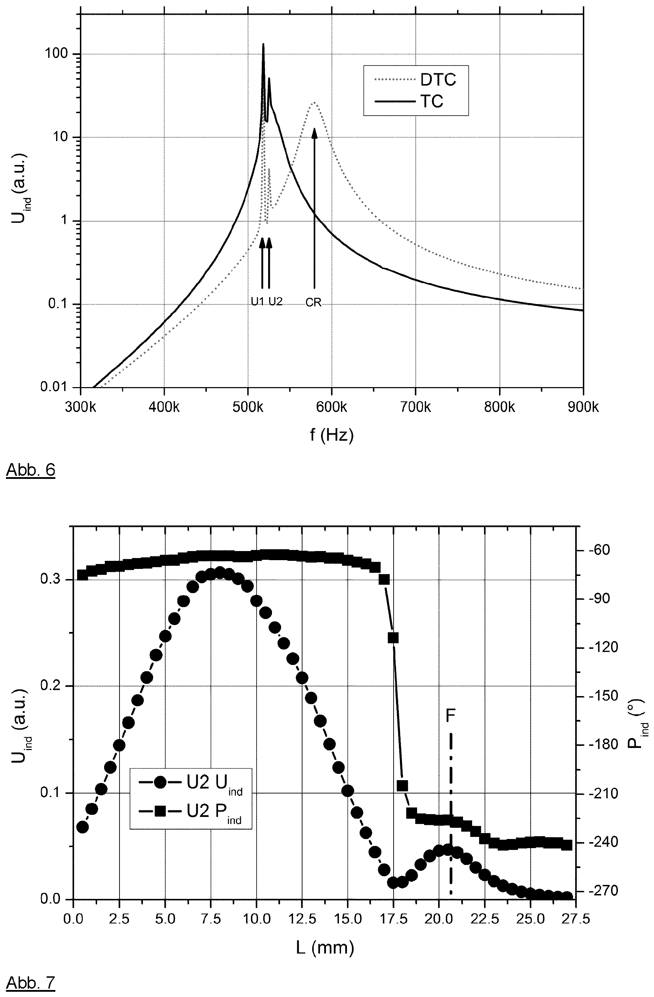

Hayes et al. untersuchen die mechanische Deformation des Streifens bei den gefundenen Frequenzen mittels optischer Vibrometrie und fassen ihren Befund in der dortigen Abb. 6 zusammen. Sie folgern daraus, dass die vorliegende Resonanzschwingung in beiden Fällen eine Kombination aus bekannten Biegemoden und Torsionsmoden aufweist.

Es ist nun die Aufgabe der Erfindung, eine verbesserte Magnetfeldmessvorrichtung nach dem Prinzip der magnetfeldsensitiven, resonanten Schwingung eines Auslegers vorzuschlagen.

Die Aufgabe wird gelöst durch eine Magnetfeldmessvorrichtung aufweisend einen einseitig eingespannten, mechanisch schwingungsfähigen, rechteckigen Substratstreifen, wobei wenigstens eine Flachseite des Substratstreifens mit einem magnetostriktiven Materialsystem beschichtet ist, weiterhin aufweisend Antriebsmittel ausgebildet zur zeitlich periodischen Ausübung einer senkrecht zu den Flachseiten des Substratstreifens gerichteten Kraftkomponente auf wenigstens einen Teil einer Flachseite des Substratstreifens mit einer vorbestimmten Anregungsfrequenz und aufweisend eine Detektionseinrichtung zur Erfassung eines durch die Schwingung des Substratstreifes erzeugten elektrischen Signals, wobei
a. der Substratstreifen aus einem Material mit einem Elastizitätsmodul größer als 5 GPa gebildet ist und
b. die Detektionseinrichtung eine den Substratstreifen kontaktlos umgebende Induktionsspule mit entlang des Substratstreifens ausgerichteter Spulenachse aufweist,
   dadurch gekennzeichnet, dass
   - die Anregungsfrequenz in Abhängigkeit der Abmessungen des Substratstreifens so eingerichtet ist, dass der Substratstreifen in mechanischer Resonanz schwingend eine U-Mode ausbildet, wobei U-Moden Moden sind, die vorrangig Verbiegungen in Form eines symmetrischen Bogens geöffnet nach oben oder unten des Substratstreifens entlang der kurzen Achse zeigen und
   - die U-Mode mit wenigstens einer Knotenlinie ausgebildet ist und
   - die Induktionsspule aus wenigstens zwei koaxialen, nicht überlappenden, in Serie geschalteten Teilspulen gebildet ist, wobei je zwei benachbarte Teilspulen gegenläufigen Wicklungssinn aufweisen und auf verschiedenen Seiten der wenigstens einen Knotenlinie angeordnet sind.

Die Unteransprüche geben vorteilhafte Ausgestaltungen.

Als Vorbemerkung sei gesagt, dass die Merkmale a. und b. an sich üblich und dem Fachmann geläufig sind, in Kombination mit den kennzeichnenden Merkmalen aber hier auch als notwendig angesehen werden. Das Einrichten der Anregungsfrequenz in Abhängigkeit der Abmessungen des Substratstreifens so, dass der Substratstreifen in mechanischer Resonanz schwingend eine U-Mode ausbildet, wiederum ist leicht ausführbar und ein neuer Schlüsselschritt zur Konstruktion verbesserter Magnetfeldmessvorrichtungen.

Dies wird im Folgenden näher erläutert anhand der Abbildungen. Dabei zeigt:
- Abb. 1: graphische Darstellungen numerisch simulierter U-Moden bei der resonanten Streifenschwingungen, nämlich a) Mode U1 ohne Knotenlinie und b) Mode U2 mit einer Knotenlinie entlang der kurzen Achse;
- Abb. 2: eine Skizze des Messaufbaus von Hayes et al. (Stand der Technik);
- Abb. 3: induzierte Spannungsmesswerte am Ausgang der Induktionsspule im Aufbau nach Abb. 2 über das Frequenzband 0 - 1,5 MHz;
- Abb. 4: Messdaten der Amplituden und Phasen der resonanten Oszillation des Streifens aus Hayes et al. gemessen mit hochgenauer Laservibrometrie;
- Abb. 5: Frequenzen des Auftretens der U-Moden U1 und U2 bei der resonanten Oszillation des Streifens in Abhängigkeit von a) der Dicke des Streifens (berechnet) und b) der Breite des Streifens (berechnet);
- Abb. 6: Effekt einer kapazitiven Trimmung der elektrischen Resonanzfrequenz der Induktionsspule;
- Abb. 7: Plot der gemessenen Amplituden und Phasen der Mode U2 entlang der langen Streifenachse.

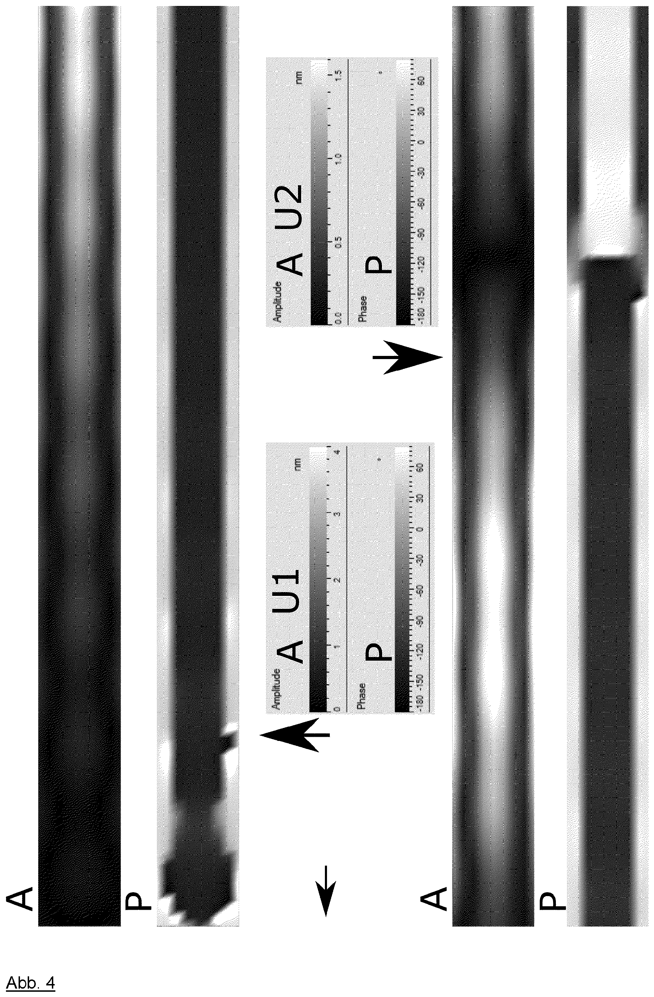

Es ist zunächst festzustellen, dass Hayes et al. sich in ihrer Arbeit bezüglich der mechanischen Deformation des Sensorstreifens geirrt haben, wie in der Zwischenzeit durchgeführte weitere Laservibrometer-Messungen belegen. Die neuen Messdaten sind in der Abb. 4 als Graustufen-Plots dargestellt und können mit der Abb. 6 aus der Arbeit von Hayes et al. verglichen werden. Der Pfeil nach links weist auf die Einspannseite der Streifen. Die neueren Messungen wurden von einer auf Oberflächenvibrometrie spezialisierten Arbeitsgruppe mit deren optimiertem Equipment durchgeführt. Es wurde dabei ein baugleicher Sensorstreifen bei den von Hayes et al. gefundenen Frequenzen 515,7 kHz und 520,7 kHz untersucht.

Hayes et al. haben ihre ursprünglichen - fehlerhaften - Messwerte nicht im Grundsatz angezweifelt, weil sie sich im Einklang mit den vorbekannten üblichen Biege- und Torsionsresonanzmoden interpretieren ließen. Die in Abb. 3 dieser Beschreibung dargestellte herausragende Responsivität des Sensorstreifens für die beiden besagten Frequenzen wurde zunächst als berichtenswerter, aber in seiner Ursache nicht genau begründbarer, Sonderfall betrachtet. Wie sich herausgestellt hat, weist die Arbeit von Hayes et al. damit in die falsche Richtung.

Die Messdaten der Abb. 4 gaben zunächst Anlass, das Schwingungsverhalten eines Substratstreifens aus Silizium bei einseitiger Einspannung und Krafteintrag senkrecht zu den Flachseiten auf der gesamten Fläche einer Flachseite numerisch zu modellieren. Dafür wurde eine vorbestehende Software basierend auf der Finite-Elemente-Methode (FEM) benutzt und an die Problemstellung angepasst. Der Sensorstreifen von Hayes et al. besteht fast nur aus dem Substratstreifen, d.h. den Funktionsdünnschichten wird kein nennenswerter Effekt auf die mechanischen Moden zuerkannt.

Das wesentliche Modellierungsergebnis ist in der Abb. 1 dieser Beschreibung dargestellt. Die Erfinder entdeckten die Mode U1 bei 515,7 kHz und die Mode U2 bei 520,7 kHz, nunmehr in Einklang stehend mit den Messungen der Abb. 4. Die Moden U1 und U2 sind die einzigen sogenannten U-Moden 4, die sich im untersuchten Frequenzband 0 - 1,5 MHz auffinden lassen.

Die U-Moden 4 zeichnen sich leicht erkennbar dadurch aus, dass sie eine maximale Verbiegung des Substratstreifens 1 entlang seiner kurzen Achse mit sich bringen, was ganz erhebliche Kräfte erfordert. Tatsächlich wurde im Experiment gefunden, dass man die Amplitude der Anregung soweit erhöhen kann, dass der Substratstreifen 1 entlang seiner langen Achse durchbricht. Es sind diese ausgeprägten Wölbungen des Substratstreifens 1, die sich auch auf die magnetostriktive Funktionsschicht übertragen und so die überragende Resonanzverstärkung des Sensors bewirken.

Die Grundidee der vorliegenden Erfindung ist daher, die Ausbildung von U-Moden 4 auf Substratstreifen 1 in Magnetfeldmessvorrichtungen mit magnetostriktiven bzw. magnetostriktiv beschichten Resonanzschwingern zu befördern und hiernach auszunutzen.

Das geeignete Mittel der Wahl, um für verschiedene Magnetfeldmessvorrichtungen U-Moden 4 zu finden und zu realisieren, ist erneut die FEM-Modellierung. Anhand ihrer Eigenschaft des Auftretens extremaler Krümmungen entlang der kurzen Streifenachse lassen sich die berechneten Resonanzmoden leicht in U-Moden 4 und andere trennen, und man findet, dass sich die Moden U1 und U2 in einer breiten geometrischen Variation von Substratstreifen 1 gezielt anregen lassen.

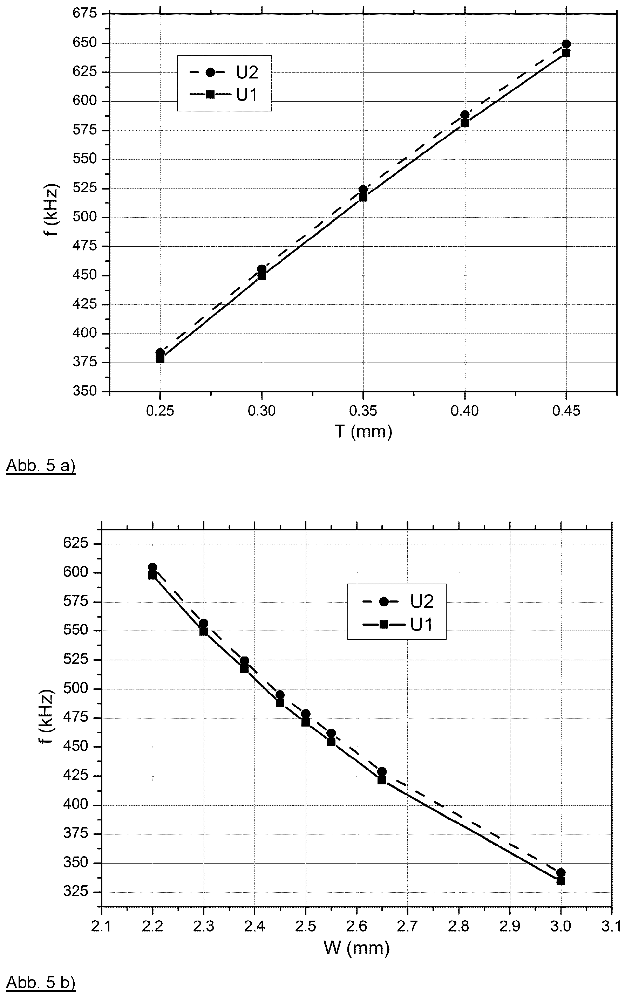

Die Abbildungen 5 a) und 5 b) stellen die ersten berechneten Ergebnisse als Punkte dar, die sich gut erkennbar leicht interpolieren lassen. In den Simulationen wird zunächst von einem Siliziumstreifen in der Geometrie von Hayes et al. ausgegangen und dann eine der Dimensionierungen variiert. Abb. 5 a) zeigt auf, dass ein Silizium-Substratstreifen der Dicke T aus dem Intervall 0,25 - 0,45 Millimeter zu den Moden U1 und U2 angeregt werden kann, wenn die Anregungsfrequenz dazu passend auf einen Wert aus dem Intervall von ca. 380 kHz bis ca. 640 kHz eingerichtet wird. In Abb. 5 b) wiederum wird die Breite W des Substratstreifens im Intervall 2,2 - 3,0 Millimeter variiert, und die Anregungsfrequenz für die U-Moden nimmt mit zunehmender Streifenbreite von etwa 600 kHz auf ca. 335 kHz ab.

Nicht gezeigt ist die Änderung der Anregungsfrequenz mit der Streifenlänge L, weil diese sich in der Modellierung als sehr gering erweist. Es sei daran erinnert, dass die Krafteinleitung durch das Piezoelektrikum auf die gesamte Fläche einer Flachseite des Streifens stattfindet. Dass die Länge des einseitig eingespannten, ansonsten frei schwingenden Streifens nur eine untergeordnete Rolle spielt, ist dadurch einerseits nachvollziehbar und andererseits auch für die praktische Befestigung an einem Haltekörper 3 hilfreich, da es dann z.B. auf die Genauigkeit der Länge der Verklebung eher wenig ankommt.

Die bisherigen Erläuterungen sollen verdeutlichen, dass die U-Moden 4 zwar ein Sonderfall von Resonanzmoden schwingender Substratstreifen 1 sind, aber keineswegs nur beschränkt für ein vorbestimmtes Materialsystem oder eine vorbestimmte Streifengeometrie auftreten. Sie sind vielmehr weithin verfügbar und können gezielt aufgesucht und realisiert werden. Dabei liegen die Anregungsfrequenzen der U-Moden 4 jedoch weit oberhalb jener Frequenzen, für die die Biegeschwinger üblich konzipiert werden. Beispielsweise zeigt der Sensorstreifen von Hayes et al. seine ersten resonanten Biegemoden bereits bei 1 kHz und 5 kHz.

Die FEM-Modellrechnungen weisen darauf hin, dass sich die U-Moden 4 nicht für Substratstreifen 1 einstellen, die sich zu leicht deformieren lassen. Bei einer Simulation der Resonanzmoden eines Substratstreifens 1 aus einem Kunststoff mit Elastizitätsmodul 5 GPa konnten keine U-Moden 4 modelliert werden. Es wird vermutet, dass sich Polymere generell eher nicht als Substratmaterial eignen, um U-Moden 4 hervorzurufen. Die größten Elastizitätsmoduln für Polymere liegen bei 20 GPa, so dass das Substratmaterial bevorzugt einen höheren Wert als 20 GPa aufweisen sollte. Besonders bevorzugt ist der Substratstreifen 1 aus einer Keramik, einem Halbleiter oder aus einem Glas gebildet, insbesondere aus Materialien mit einem Elastizitätsmodul größer als 75 GPa. In einer besonders bevorzugten Ausgestaltung ist der Substratstreifen 1 aus einem monokristallinen Halbleiter, ganz besonders bevorzugt aus Silizium, gebildet.

In Experimenten wurde weiterhin überprüft, ob die ganzflächige Bedeckung des Substratstreifens 1 mit einer piezoelektrischen Funktionsschicht als ein Antriebsmittel zur Erregung der resonanten Streifenschwingung eine Notwendigkeit zur Erzeugung von U-Moden 4 ist. Dies ist aber nicht der Fall, vielmehr reicht die Einleitung einer Kraftkomponente senkrecht zu den Flachseiten bereits auf einer Teilfläche einer Flachseite zur Erzeugung von U-Moden 4 aus.

Zur Beurteilung wurde die Präsenz der prominenten Peaks bei 515,7 kHz und 520,7 kHz in Abb. 3 herangezogen, während die Bedeckung mit der Piezoschicht auf etwa 30 % der Fläche des Substratstreifens 1 zurückgenommen wurde. Dabei wurde die Beschichtung auf der Einspannseite unmittelbar ab der mechanischen Klemmung aufgebracht. Dies wird als die "ungünstigste" Wahl der Teilfläche des Streifens angesehen, die den Piezoantrieb tragen soll. Insofern erscheint eine Anregung auf 30 % der Streifenfläche als grundsätzlich immer ausreichend.

Die Erkenntnis, dass eine Schwingungserregung über eine Teilfläche des Streifens zur Ausbildung der U-Moden 4 ausreicht, ist für die Praxis bedeutsam, weil in vielen Fällen die Schwingungsenergie von der Einspannseite her in den Streifen eingetragen werden soll. Dafür sind Antriebsvorrichtungen wie Piezotransducer oder elektrostatische Mikroantriebe am Haltekörper 3 angeordnet, die von elektrischen Frequenzgeneratoren angesteuert werden. Man hat somit eine größere Freiheit bei der Auswahl und Anordnung der Antriebsmittel und ist insbesondere nicht darauf angewiesen, einen klassischen ME-Bimorph als Streifenschwinger zu verwenden.

Gleichwohl wird es als bevorzugte Ausgestaltung betrachtet, dass die Antriebsmittel einen elektrischen Frequenzgenerator und wenigstens einen Piezotransducer umfassen, wobei der wenigstens eine Piezotransducer auf der Flachseite des Substratstreifens 1 angeordnet ist, welche der mit dem magnetostriktiven Materialsystem beschichteten Flachseite gegenüberliegt. Vorzugsweise ist dabei der wenigstens eine Piezotransducer als Dünnschicht ausgeführt, besonders bevorzugt als gesputtertes Aluminiumnitrid zwischen zwei Metallschichten. Auf diese Weise steht der Piezotransducer der Verbiegung des Substratstreifens 1 in den U-Moden 4 nicht sperrend entgegen, sondern kann die Verbiegungen offenbar mitmachen unter Beibehaltung eines guten mechanischen Kontakts zum Substratmaterial. In der Ausgestaltung als Dünnschicht ist es möglich und vorteilhaft, dass der wenigstens eine Piezotransducer die Flachseite vollständig bedeckt.

Für den Zweck der Magnetfeldmessung wird die Detektion der durch die U-Moden 4 erzeugten Magnetflussänderungen in der magnetostriktiven Materialphase mittels Induktionsspulen 2 als notwendig erachtet. Dabei ist es allerdings nicht zwingend, dass die Induktionsspule 2 jederzeit die gesamte Länge des schwingenden Streifens umgibt. Insbesondere kann es von Vorteil sein, eine kürzere Spule vorzusehen, die im Bereich eines vorbekannten Amplitudenbauches der Moden U1 oder U2 angeordnet ist oder dahin bewegt wird.

Überdies besteht die Möglichkeit, die Induktionsspulen mittels einfacher apparativer Änderungen besonders responsiv für die hier angestrebten U-Moden auszugestalten.

Jede reale Spule weist neben ihrer Induktivität auch ohmsche und kapazitive Schaltkreisanteile auf, die in einem Ersatzschaltbild zu berücksichtigen sind. Insbesondere ist auch eine offene Spule ohne Last oder mit einem hochohmigen Eingangswiderstand eines Operationsverstärkers am Ausgang ein elektrischer Schwingkreis mit Eigenfrequenz. Die mechanische Frequenz des Streifenschwingers und die elektrische Eigenfrequenz der Spule liegen hier relativ nah beieinander. Dies kann vorteilhaft ausgenutzt werden.

In Abb. 6 ist die induzierte Spulenspannung über das Frequenzband 300 - 900 kHz dargestellt. Die gepunktete Linie zeigt die beiden Peaks der Moden U1 und U2 und ein breites Maximum CR, das von der elektrischen Eigenfrequenz der Spule bei etwa 580 kHz herrührt (DTC - "detuned coil"). Schaltet man der Spule eine zusätzliche, veränderliche Kapazität parallel, so kann man dadurch die Eigenfrequenz herabsetzen, vorzugsweise soweit, dass die Induktionsspule 2 als elektrischer Schwingkreis eine Resonanzfrequenz aufweist nahe einer mechanischen Resonanzfrequenz des Substratstreifens 1, bei der eine U-Mode 4 ausgebildet wird.

Der elektrische Spulenresonator ist in der Regel von geringer Güte und weist eine große Halbwertsbreite des Resonanzpeaks auf (vgl. Abb. 6., CR). Die mechanische Resonanzfrequenz des Streifenschwingers sollte bevorzugt innerhalb der Halbwertsbreite der elektrischen Spulenresonanz liegen. Entsprechend weit soll die Eigenfrequenz der Spule mittels Trimmung an die Frequenzen der U-Moden 4 herangeführt werden.

Auf diese Weise erhält man die Daten der durchgezogenen Linie (TC - "tuned coil") in Abb. 6 als induzierte Spannung. Man beachte auch hier die logarithmische Skala: die Messwerte werden um etwa eine Größenordnung erhöht. Da das unvermeidliche Rauschen der nachgeschalteten Messelektronik von dieser zusätzlichen Maßnahme zur Resonanzüberhöhung nicht erfasst wird, steigt der Signal-Rausch-Abstand entsprechend erheblich an.

Es ist somit eine bevorzugte Ausgestaltung der Magnetfeldmessvorrichtung, dass sie einen der Induktionsspule 2 parallel geschalteten Trimmkondensator aufweist. Es ist zu betonen, dass eine Trimmung der parallel geschalteten Kapazität voraussetzt, dass die Resonanzfrequenzen der mechanischen Anregung und der elektrischen Spulenschwingung schon vor der Trimmung vergleichbar groß sind, was speziell für die U-Moden 4 hier der Fall ist.

In Abb. 7 sind die mit einem verschiebbaren kurzen Spulenring gemessene Phase (P_{ind}) und Amplitude (U_{ind}) der Mode U2 bei 520,7 kHz entlang der langen Streifenachse geplottet (Einspannseite ist links). Die Längenskala ist messbedingt verschoben, zur besseren Orientierung ist das freie Streifenende durch die vertikale Linie mit Notierung F markiert. Der kurze Spulenring erzeugt lokalisierte Messwerte aus der Umgebung des Streifensegments, das sich gerade im Zentrum der Spule befindet. Er eignet sich sehr gut zum Auffinden von Knotenlinien, die senkrecht zur langen Achse verlaufen. Eine solche liegt bei der Marke von etwa 17,5 mm vor, wo die Amplitude minimal wird und die Phase um 180° springt. Die genaue Lage der Knotenlinie von U2 kann für jeden Sensoraufbau einmalig ermittelt werden.

Wenn eine gewöhnliche Induktionsspule 2 den Streifenschwinger über seine gesamte Länge hinweg umgibt, dann wird die gegenphasige Bewegung des magnetischen Materials zu beiden Seiten der Knotenlinie bewirken, dass Spannungen entgegengesetzter Polarität gleichzeitig induziert werden. Im Ergebnis wird das elektrische Ausgangssignal der Induktionsspule 2 durch diese innere Aufhebung abgeschwächt. Um dies zu vermeiden, kann man die Induktionsspule 2 in koaxiale, nicht überlappende Teilspulen aufteilen. Die Teilspulen können separate, jeweils lokalisierte Induktionsspannungen messen, die z.B. separat erfasst und hiernach dem Betrage nach addiert werden können.

Um allerdings den technischen Messaufwand und die Rauschquellen gering zu halten, ist es eine bevorzugte Ausgestaltung der Magnetfeldmessvorrichtung, dass der Substratstreifen 1 in mechanischer Resonanz schwingend eine U-Mode 4 mit wenigstens einer Knotenlinie ausbildet und die Induktionsspule 2 aus wenigstens zwei koaxialen, nicht überlappenden, in Serie geschalteten Teilspulen gebildet ist, wobei je zwei benachbarte Teilspulen gegenläufigen Wicklungssinn aufweisen und auf verschiedenen Seiten der wenigstens einen Knotenlinie angeordnet sind. Auf diese Weise addieren sich die induzierten Spannungen in der Serienschaltung direkt und können maximal verstärkt erfasst werden.

### Bezugszeichenliste

- 1: Substratstreifen
- 2: Induktionsspule
- 3: Haltekörper
- 4: U-Mode
- 41: U-Mode ohne Knotenlinie
- 42: U-Mode mit Knotenlinie

## Patentansprüche

1. Magnetfeldmessvorrichtung aufweisend einen einseitig eingespannten, mechanisch schwingungsfähigen, rechteckigen Substratstreifen (1), wobei wenigstens eine Flachseite des Substratstreifens (1) mit einem magnetostriktiven Materialsystem beschichtet ist, weiterhin aufweisend Antriebsmittel ausgebildet zur zeitlich periodischen Ausübung einer senkrecht zu den Flachseiten des Substratstreifens (1) gerichteten Kraftkomponente auf wenigstens einen Teil einer Flachseite des Substratstreifens (1) mit einer vorbestimmten Anregungsfrequenz und aufweisend eine Detektionseinrichtung zur Erfassung eines durch die Schwingung des Substratstreifens (1) erzeugten elektrischen Signals, **wobei**
a. der Substratstreifen (1) aus einem Material mit Elastizitätsmodul größer als 5 GPa gebildet ist
und
b. die Detektionseinrichtung eine den Substratstreifen (1) kontaktlos umgebende Induktionsspule (2) mit entlang des Substratstreifens (1) ausgerichteter Spulenachse
aufweist,
**dadurch gekennzeichnet, dass**
- die Anregungsfrequenz in Abhängigkeit der Abmessungen des Substratstreifens (1) so eingerichtet ist, dass der Substratstreifen (1) in mechanischer Resonanz schwingend eine U-Mode (4) ausbildet, wobei U-Moden (4) Moden sind, die vorrangig Verbiegungen in Form eines symmetrischen Bogens geöffnet nach oben oder unten des Substratstreifens (1) entlang der kurzen Achse zeigen und
- die U-Mode (4) mit wenigstens einer Knotenlinie ausgebildet ist und
- die Induktionsspule (2) aus wenigstens zwei koaxialen, nicht überlappenden, in Serie geschalteten Teilspulen gebildet ist, wobei je zwei benachbarte Teilspulen gegenläufigen Wicklungssinn aufweisen und auf verschiedenen Seiten der wenigstens einen Knotenlinie angeordnet sind.

2. Magnetfeldmessvorrichtung nach Anspruch 1,
**dadurch gekennzeichnet, dass**
der Substratstreifen (1) aus einem Material mit Elastizitätsmodul größer als 20 GPa, bevorzugt größer als 75 GPa, gebildet ist.

3. Magnetfeldmessvorrichtung nach Anspruch 2,
**dadurch gekennzeichnet, dass**
der Substratstreifen (1) aus einer Keramik, einem Halbleiter oder aus einem Glas gebildet ist.

4. Magnetfeldmessvorrichtung nach einem der vorangehenden Ansprüche,
**dadurch gekennzeichnet, dass**
der Substratstreifen (1) aus einem monokristallinen Halbleiter, vorzugsweise aus Silizium, gebildet ist.

5. Magnetfeldmessvorrichtung nach einem der vorangehenden Ansprüche,
**dadurch gekennzeichnet, dass**
die Antriebsmittel einen elektrischen Frequenzgenerator und wenigstens einen Piezotransducer umfassen, wobei der wenigstens eine Piezotransducer auf der Flachseite des Substratstreifens (1) angeordnet ist, welche der mit dem magnetostriktiven Materialsystem beschichteten Flachseite gegenüberliegt.

6. Magnetfeldmessvorrichtung nach Anspruch 5,
**dadurch gekennzeichnet, dass**
der wenigstens eine Piezotransducer als Dünnschicht ausgeführt ist, vorzugsweise als gesputtertes Aluminiumnitrid zwischen zwei Metallschichten.

7. Magnetfeldmessvorrichtung nach Anspruch 6,
**dadurch gekennzeichnet, dass**
der wenigstens eine Piezotransducer die Flachseite vollständig bedeckt.

8. Magnetfeldmessvorrichtung nach einem der vorangehenden Ansprüche,
**dadurch gekennzeichnet, dass**
die Induktionsspule (2) als elektrischer Schwingkreis eine Resonanzfrequenz aufweist und die mechanische Resonanzfrequenz des Substratstreifens (1), bei der eine U-Mode (4) ausgebildet wird, innerhalb der Halbwertsbreite der Spulenresonanz liegt.

9. Magnetfeldmessvorrichtung nach Anspruch 8,
**dadurch gekennzeichnet, dass**
die Magnetfeldmessvorrichtung einen der Induktionsspule (2) parallel geschalteten Trimmkondensator aufweist.

## Claims

1. Magnetic field measuring device comprising a mechanically vibratable rectangular substrate strip (1) clamped on one side, wherein at least one flat side of the substrate strip (1) is coated with a magnetostrictive material system, further comprising drive means designed for periodically exerting a force component directed perpendicular to the flat sides of the substrate strip (1) on at least part of a flat side of the substrate strip (1) with a predetermined excitation frequency, and comprising a detection device for detecting an electrical signal generated by the vibration of the substrate strip (1),
**wherein**
a. the substrate strip (1) is formed from a material with a modulus of elasticity greater than 5 GPa
and
b. the detection device comprises an induction coil (2) which surrounds the substrate strip (1) without contact and has a coil axis aligned along the substrate strip (1),
**wherein**
- the excitation frequency is set as a function of the dimensions of the substrate strip (1) such that the substrate strip (1) forms a U-mode (4) oscillating in mechanical resonance, wherein U-modes (4) are modes which primarily exhibit bending in the form of a symmetrical arc open upwards or downwards of the substrate strip (1) along the short axis, and
- the U-mode (4) is formed with at least one node line and
- the induction coil (2) is formed from at least two coaxial, non-overlapping partial coils connected in series, wherein two adjacent partial coils have opposite winding directions and are arranged on different sides of the at least one node line.

2. Magnetic field measuring device according to claim 1,
**wherein**
the substrate strip (1) is formed from a material with a modulus of elasticity greater than 20 GPa, preferably greater than 75 GPa.

3. Magnetic field measuring device according to claim 2,
**wherein**
the substrate strip (1) is formed from a ceramic, a semiconductor or from glass.

4. Magnetic field measuring device according to one of the preceding claims,
**wherein**
the substrate strip (1) is formed from a monocrystalline semiconductor, preferably silicon.

5. Magnetic field measuring device according to one of the preceding claims,
**wherein**
the drive means comprise an electrical frequency generator and at least one piezo transducer, wherein the at least one piezo transducer is arranged on the flat side of the substrate strip (1) which is opposite to the flat side coated with the magnetostrictive material system.

6. Magnetic field measuring device according to claim 5,
**wherein**
the at least one piezo transducer is designed as a thin film, preferably as sputtered aluminum nitride between two metal layers.

7. Magnetic field measuring device according to claim 6,
**wherein**
the at least one piezo transducer completely covers the flat side.

8. Magnetic field measuring device according to one of the preceding claims,
**wherein**
the induction coil (2) as an electrical oscillating circuit comprising a resonance frequency and the mechanical resonance frequency of the substrate strip (1), at which a U-mode (4) is formed, being within the half-value width of the coil resonance.

9. Magnetic field measuring device according to claim 8,
**wherein**
the magnetic field measuring device comprises a trimming capacitor connected in parallel with the induction coil (2).

## Revendications

1. Dispositif de mesure de champ magnétique comprenant une bande de substrat rectangulaire (1) fixée d'un côté, susceptible de vibrations mécaniques, dans laquelle au moins un côté plat de la bande de substrat (1) est recouvert d'un système de matériau magnétostrictif, comprenant en outre des moyens d'entraînement conçus pour exercer périodiquement une composante de force dirigée perpendiculairement aux côtés plats de la bande de substrat (1) sur au moins une partie d'un côté plat de la bande de substrat (1) avec une fréquence d'excitation prédéterminée, et comprenant un dispositif de détection pour détecter un signal électrique généré par la vibration de la bande de substrat (1), **dans laquelle**
a. la bande de substrat (1) est formée d'un matériau ayant un module d'élasticité supérieur à 5 GPa
et
b. le dispositif de détection comporte une bobine d'induction (2) entourant sans contact la bande de substrat (1) avec un axe de bobine aligné le long de la bande de substrat (1),
**caractérisé en ce que**
- la fréquence d'excitation est réglée en fonction des dimensions de la bande de substrat (1) de telle sorte que la bande de substrat (1) forme, en oscillant en résonance mécanique, un mode U (4), les modes U (4) étant des modes qui présentent principalement des flexions sous la forme d'un arc symétrique ouvert vers le haut ou vers le bas de la bande de substrat (1) le long de l'axe court, et
- le mode U (4) est formé avec au moins une ligne de nœud et
- la bobine d'induction (2) est formée d'au moins deux bobines partielles coaxiales, non superposées, montées en série, dans laquelle deux bobines partielles voisines ont un sens d'enroulement opposé et sont disposées sur des côtés différents de la au moins une ligne de nœud.

2. Dispositif de mesure de champ magnétique selon la revendication 1,
**caractérisé en ce que**
la bande de substrat (1) est constituée d'un matériau ayant un module d'élasticité supérieur à 20 GPa, de préférence supérieur à 75 GPa.

3. Dispositif de mesure de champ magnétique selon la revendication 2,
**caractérisé en ce que**
la bande de substrat (1) est formée d'une céramique, d'un semi-conducteur ou d'un verre.

4. Dispositif de mesure de champ magnétique selon l'une des revendications précédentes,
**caractérisé en ce que**
la bande de substrat (1) est formée d'un semi-conducteur monocristallin, de préférence en silicium.

5. Dispositif de mesure de champ magnétique selon l'une des revendications précédentes,
**caractérisé en ce que**
les moyens d'entraînement comprennent un générateur de fréquence électrique et au moins un transducteur piézoélectrique, dans laquelle le au moins un transducteur piézoélectrique est disposé sur le côté plat de la bande de substrat (1) qui est opposé au côté plat revêtu du système de matériau magnétostrictif.

6. Dispositif de mesure de champ magnétique selon la revendication 5,
**caractérisé en ce que**
le au moins un transducteur piézoélectrique est réalisé sous forme de couche mince, de préférence sous forme de nitrure d'aluminium pulvérisé entre deux couches métalliques.

7. Dispositif de mesure de champ magnétique selon la revendication 6,
**caractérisé en ce que**
le au moins un transducteur piézoélectrique recouvre complètement le côté plat.

8. Dispositif de mesure de champ magnétique selon l'une des revendications précédentes,
**caractérisé en ce que**
la bobine d'induction (2) présente, en tant que circuit oscillant électrique, une fréquence de résonance et la fréquence de résonance mécanique de la bande de substrat (1), à laquelle un mode U (4) est formé, se situe à l'intérieur de la demi-largeur de résonance de la bobine.

9. Dispositif de mesure de champ magnétique selon la revendication 8,
**caractérisé en ce que**
le dispositif de mesure du champ magnétique comporte un condensateur d'ajustement connecté en parallèle à la bobine d'induction (2).
